# EUROPEAN PATENT APPLICATION

(11) **EP 4 273 294 A1**
(43) Date of publication of application: **08.11.2023**
(21) Application number: 23171175.5
(22) Date of filing: 02.05.2023
(51) Int. Cl.: C23C 14/04, C23C 14/56, H01L 21/027, H01L 21/67, H01L 21/673, H01L 21/68, H01L 21/683, H10K 71/16, C23C 14/24, C23C 14/50, H01L 21/677

(54) **APPARATUS FOR MANUFACTURING DISPLAY DEVICE AND METHOD OF MANUFACTURING DISPLAY DEVICE**

(30) Priority: 03.05.2022 KR 20220055021
(71) Applicant: Samsung Display Co., Ltd., Yongin-si, Gyeonggi-do 17113 (KR)
(72) Inventor: Cho, Youngsun, 17113 Yongin-si (KR); Kim, Jangwoo, 17113 Yongin-si (KR); Yi, Sangmin, 17113 Yongin-si (KR); Chung, Kyunghoon, 17113 Yongin-si (KR); Hong, Jaemin, 17113 Yongin-si (KR)
(74) Representative: Taor, Simon Edward William

(57) **Abstract**

An apparatus for manufacturing a display device includes: a mask assembly tilted with respect to one plane parallel to a ground; a support unit configured to support one surface of the mask assembly and to support a lower surface of the mask assembly; a deposition source arranged to face the mask assembly; and a carrier arranged to face the mask assembly and configured to support a display substrate.

## Description

### CROSS-REFERENCE TO RELATED APPLICATION

This application claims priority to and the benefit of Korean Patent Application No. 10-2022-0055021, filed on May 3, 2022, in the Korean Intellectual Property Office.

### BACKGROUND

### 1. Field

Aspects of embodiments of the present disclosure relate to an apparatus for manufacturing a display device and a method of manufacturing a display device.

### 2. Description of the Related Art

Mobile electronic devices are in wide use. Some examples of mobile electronic devices in wide use recently include small electronic devices, such as mobile phones and tablet personal computers (PCs).

Such mobile electronic devices include display devices to provide various functions, for example, to provide visual information, such as images or videos to users. Recently, as other parts for driving display devices have been miniaturized, the portion of the mobile electronic device occupied by a display device has gradually been increasing. A structure that is bendable to form a certain angle from a flat state is also under development.

A display device as described above may include a plurality of pixels arranged in a pattern to implement (or display) an image. The pixels may include an intermediate layer including an emission layer. A pattern of the plurality of intermediate layers are disposed on a substrate according to the type of intermediate layer.

### SUMMARY

When an intermediate layer is disposed on a substrate in the form of a pattern, the quality of an image implemented in (or displayed by) a display device is determined according to how accurately the intermediate layer is disposed. Thus, deformation of a mask assembly used to form (e.g., deposit) the intermediate layer in the form of a pattern is an important consideration when the intermediate layer is formed. One or more embodiments of the present disclosure include an apparatus for manufacturing a display device and a method of manufacturing a display device in which deformation of a mask assembly is reduced.

Additional aspects and features of the present disclosure will be set forth, in part, in the description that follows and, in part, will be apparent from the description or may be learned by practice of the embodiments of the present disclosure described herein.

According to an embodiment of the present disclosure, an apparatus for manufacturing a display device includes: a mask assembly tilted with respect to one plane parallel to a ground; a support unit configured to support one surface of the mask assembly and support a lower surface of the mask assembly; a deposition source arranged to face the mask assembly; and a carrier arranged to face the mask assembly and configured to support a display substrate.

The support unit may include a support portion having an opening, a first support block spaced apart from the support portion and configured to support a rear surface of the mask assembly, and a second support block on a lower surface of the support portion and configured to support a side surface of the mask assembly.

A tilting angle of the mask assembly may be in a range of 3° to 14°.

The carrier may be tilted to correspond to a tilting angle of the mask assembly.

The mask assembly may include a mask frame and a mask sheet on the mask frame.

The mask assembly may further include a support member over an opening in the mask frame to partition the opening in the mask frame.

The deposition source may include: a source portion configured to accommodate and heat a deposition material; and a nozzle portion connected to the source portion and configured to spray the heated deposition material.

The nozzle portion may be elongated and tilted with respect to the one plane parallel to the ground.

The carrier may include a carrier body configured to fix the display substrate and a magnetic force generator on a rear surface of the carrier body.

The magnetic force generator may be on a side surface of the carrier body.

According to another embodiment of the present disclosure, a method of manufacturing a display device includes fixing a display substrate to a carrier; arranging a mask assembly to be tilted with respect to one plane parallel to a ground; and arranging one surface of the display substrate to face one surface of the mask assembly. The mask assembly is supported by a first support block on a rear surface of the mask assembly and a second support block configured to support a lower surface of the mask assembly.

The mask assembly may include a mask frame having an opening and a mask sheet on the mask frame.

The mask assembly may further include a support member arranged over the opening in the mask frame to partition the opening in the mask frame.

The method may further include arranging the mask assembly on a support portion on which the first support block and the second support block are arranged.

The carrier may be tilted to correspond to an angle at which the mask assembly is tilted.

The method may further include depositing a deposition material on the display substrate by supplying the deposition material through a deposition source.

The deposition source may include: a source portion configured to accommodate and heat a deposition material; and a nozzle portion connected to the source portion and configured to spray the heated deposition material.

The nozzle portion may be elongated and tilted with respect to the one plane parallel to the ground.

The carrier may include a carrier body configured to fix the display substrate and a magnetic force generator on a rear surface of the carrier body.

The magnetic force generator may be on a side surface of the carrier body.

According to an aspect, there is provided an apparatus for manufacturing a display device as set out in claim 1. Additional features are set out in claims 2 to 13. According to an aspect, there is provided a method as set out in claim 11. Additional features are set out in claims 12 to 15.

Other aspects and features of the present disclosure will be better understood through the accompanying drawings, the claims, and the detailed description.

These general and specific aspects and features may be practiced by using systems, methods, computer programs, or any combination thereof.

### BRIEF DESCRIPTION OF THE DRAWINGS

The above and other aspects and features of embodiments of the present disclosure will be more apparent from the following description, taken in conjunction with the accompanying drawings, in which:
FIG. 1 is a plan view schematically illustrating an apparatus for manufacturing a display device according to an embodiment;
FIG. 2 is an exploded perspective view schematically illustrating a portion of a depositing unit illustrated in FIG. 1 according to an embodiment;
FIG. 3 is a cross-sectional view illustrating the depositing unit illustrated in FIG. 1 according to an embodiment;
FIG. 4 is a graph showing pixel position accuracy (PPA) and a degree of sagging according to a tilting angle of a mask assembly illustrated in FIG. 3;
FIG. 5 is a graph showing a degree of deformation according to a tilting angle of a mask assembly illustrated in FIG. 3;
FIG. 6 is a front view illustrating a mask frame of a mask assembly in an apparatus for manufacturing a display device according to another embodiment;
FIG. 7 is a front view illustrating a mask frame of a mask assembly in an apparatus for manufacturing a display device according to another embodiment;
FIG. 8 is a plan view schematically illustrating a display device according to an embodiment;
FIG. 9 is a cross-sectional view of the display device illustrated in FIG. 8 taken along the line C-C' in FIG. 8 according to an embodiment; and
FIG. 10 is an equivalent circuit diagram schematically illustrating a pixel of the display device illustrated in FIG. 8 according to an embodiment.

### DETAILED DESCRIPTION

Reference will now be made, in detail, to embodiments, examples of which are illustrated in the accompanying drawings. Like reference numerals refer to like elements throughout. The described embodiments may have different forms and should not be construed as being limited to the descriptions set forth herein. Accordingly, examples embodiments are merely described below, by referring to the figures, to explain aspects and features of the present disclosure.

Because the present description allows for various changes and numerous embodiments, example embodiments will be illustrated in the drawings and described in detail in the written description. Aspects and features of the present disclosure, and methods of achieving them, will be clarified with reference to embodiments described below, in detail, with reference to the drawings. However, embodiments of the disclosure are not limited to the following embodiments and may be embodied in various forms.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of," when preceding a list of elements, modify the entire list of elements and do not modify the individual elements of the list. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof. The x-axis, y-axis, and z-axis are not limited to three axes of the rectangular coordinate system and may be interpreted in a broader sense. For example, the x-axis, y-axis, and z-axis may be perpendicular to one another or may represent different directions that are not perpendicular to one another.

When a certain embodiment may be implemented differently, a specific process order may be performed differently from the described order. For example, two consecutively described processes may be performed substantially at the same time or performed in an order opposite to the described order.

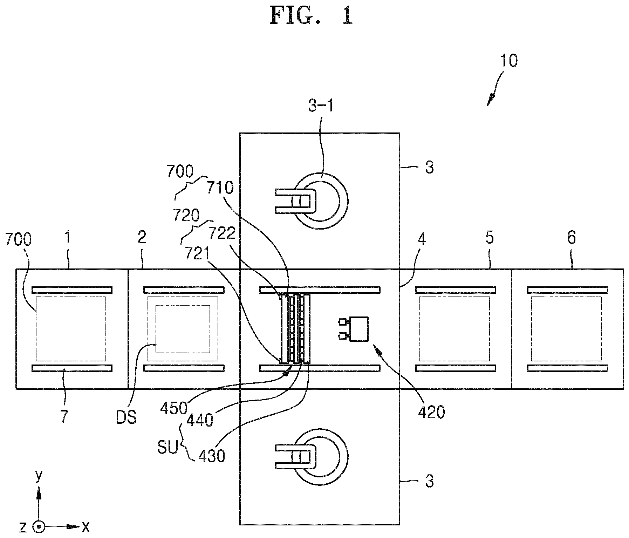

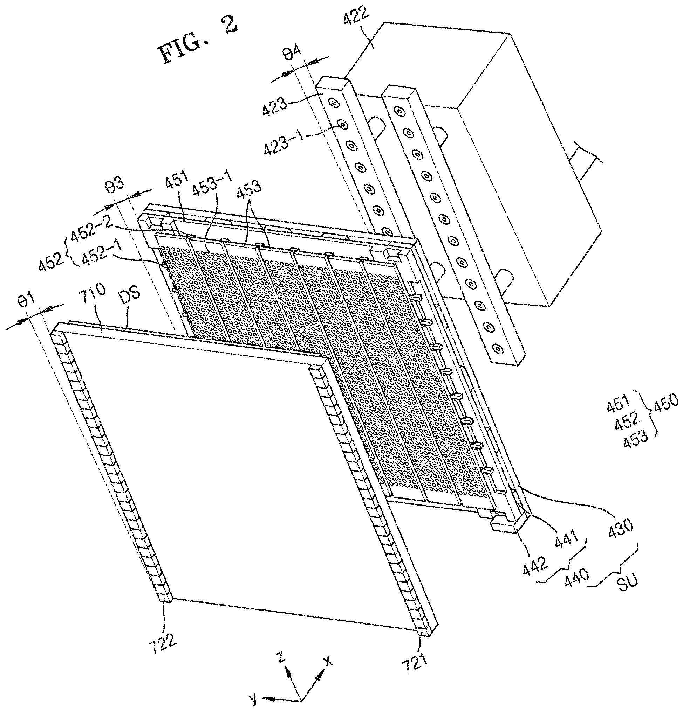

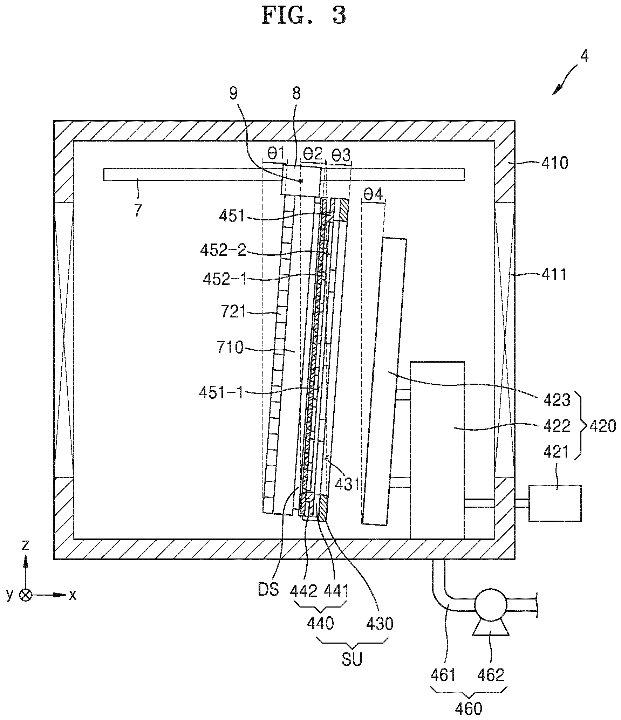

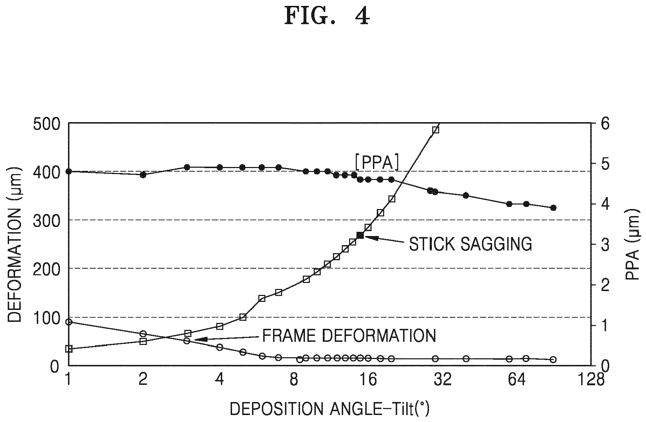

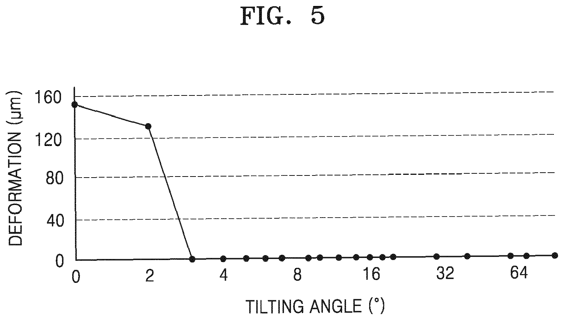

FIG. 1 is a plan view schematically illustrating an apparatus 10 for manufacturing a display device according to an embodiment. FIG. 2 is an exploded perspective view schematically illustrating a portion of a depositing unit shown in FIG. 1 according to an embodiment. FIG. 3 is a cross-sectional view illustrating the depositing unit shown in FIG. 1 according to an embodiment. FIG. 4 is a graph showing pixel position accuracy (PPA) and a degree of sagging according to a tilting angle of a mask assembly illustrated in FIG. 3. FIG. 5 is a graph showing a degree of deformation according to a tilting angle of a mask assembly illustrated in FIG. 3.

Referring to FIGS. 1 to 5, the apparatus 10 for manufacturing a display device may include a loading unit 1, a first inverting unit 2, a mask assembly loading unit 3, a depositing unit 4, and a second inverting unit 5, an unloading unit 6, and a linear driver 7.

The loading unit 1 may be a space (e.g., an area) in which a display substrate DS is loaded from the outside and is disposed on a carrier 700. For example, the carrier 700 may be configured to fix the display substrate DS in a state of being arranged in the loading unit 1. For example, the display substrate DS may be supplied to the loading unit 1 through a robot arm or the like arranged outside the loading unit 1, and the carrier 700 may attach one surface of the display substrate DS by electrostatic force. In such an embodiment, one surface of the carrier 700 to which the display substrate DS is attached may face downwardly (e.g., downwardly in a gravitational sense). The carrier 700 may be arranged to face the mask assembly 450 and configured to support a display substrate DS.

The first inverting unit 2 may be configured to invert the carrier 700. That is, the first inverting unit 2 may be configured to invert the carrier 700 so that the surface of the carrier 700 to which the display substrate DS is attached, and which faces downwardly, is made to face upwardly. For example, the first inverting unit 2 may rotate the carrier 700 by using a robot arm, a separate driver, or the like that inverts (or is configured to invert) the carrier 700. According to another embodiment, a driver, such as a motor, that is configured to rotate the carrier 700 may be arranged at a portion connecting the carrier 700 to the linear driver 7 and may be configured to rotate the carrier 700. Hereinafter, for convenience of explanation, an embodiment in which the driver is provided at a portion connecting the carrier 700 to the linear driver 7 and is configured to rotate the carrier 700 will be described in detail.

The depositing unit 4 may be connected to the first inverting unit 2 and may be configured to perform deposition on the display substrate DS. The depositing unit 4 may include a chamber 410, a support unit US, a deposition source 420, and a pressure controller 460.

The chamber 410 may be connected to the first inverting unit 2, the mask assembly loading unit 3, and the second inverting unit 5 and may have an opened portion (e.g., an opening) formed therein. An opening and closing portion 411, such as a gate valve, may be arranged in the opened portion of the chamber 410. In such an embodiment, the opening and closing portion 411 may be selectively opened to connect the chamber 410 to the first inverting unit 2, the mask assembly loading unit 3, or the second inverting unit 5.

The support unit SU may be configured to support the mask assembly 450. For example, the support unit SU may be configured to support a rear surface of the mask assembly 450 and to support a lower surface of the mask assembly 450. In such an embodiment, the support unit SU may be configured to support the mask assembly 450 such that it is tilted with respect to the lower surface of the chamber 410 (or the ground). For example, the mask assembly 450 may be arranged inside the chamber 410 in an upright state, and the support unit SU may be configured to maintain the mask assembly 450 in an upright state.

The support unit SU may include a support portion 430 having an opening 431 arranged at a central portion thereof and a plurality of support blocks 440 arranged on the surface of the support portion 430.

The support portion 430 may have a window frame shape with the opening 431 arranged at a central portion thereof. The opening 431 may be provided such that a deposition material supplied from the deposition source 420 passes therethrough. In such an embodiment, one surface of the support portion 430 may have a flat shape. The support portion 430 may be connected to the chamber 410. For example, support portion 430 may be fixed to the lower surface of the chamber 410 or may be connected to the inner surface of the chamber 410 via a separate structure. Hereinafter, for convenience of explanation, an embodiment in which the support portion 430 is fixed to the lower surface of the chamber 410 will be described in detail.

The support blocks 440 may include a first support block 441 and a second support block 442. The first support block 441 may be configured to support the one surface of the mask assembly 450 (or the one surface of the mask frame 451). For example, the first support block 441 may be configured to support the rear surface of the mask assembly 450 (e.g., the rear surface of the mask frame 451). For example, the first support block 441 may be configured to support the mask assembly 450 facing the support portion 430. A plurality of first support blocks 441 may be provided. In such an embodiment, the first support blocks 441 may be spaced apart from each other along the outer surface of the support portion 430. In some embodiments, the first support blocks 441 may each be between the support portion 430 and the mask assembly 450 and may be configured to support the mask assembly 450.

The second support block 442 may be arranged on the support portion 430 and may be configured to support the lower surface or the side surface of the mask assembly 450 (e.g., the lower surface or the side surface of the mask frame 451). For example, the second support block 442 may be configured to support one surface of the mask assembly 450 that is not supported by the first support block 441. In such an embodiment, the second support block 442 may be disposed only under the mask assembly 450.

The support unit SU may be configured to support the mask assembly 450 in a tilted state. For example, the upper portion of the mask assembly 450 may be tilted more toward (e.g., may be closer to) the deposition source 420 than the lower portion of the mask assembly 450. The tilting angle θ2 of the mask assembly 450 may be in a range of about 3° or more and about 14° or less. The tilting angle θ2 of the mask assembly 450 may refer to an angle of one flat surface of the mask assembly 450 with respect to a line segment perpendicular to the lower surface of the chamber 410 (or the ground). The tilting angle θ2 of the mask assembly 450 may refer to an angle at which the mask assembly 450 is tilted with respect to the gravitational direction. The tilt angle θ3 of the support unit SU may refer to an angle at which the support unit SU is tilted with respect to the gravitational direction.

The mask assembly 450 may include a mask frame 451, a mask sheet 453, and a support member 452.

An opening(e.g. opening area) 451-1 may be formed in the center of the mask frame 451. The mask frame 451 may be formed similarly to the support portion 430 described above. The mask frame 451 may include a protrusion on which the mask sheet 453 is seated. The protrusion may be connected along (e.g., may extend along) the periphery of the mask frame 451. In another embodiment, a portion of the mask frame 451 on which the mask sheet 453 is seated may be flat. Hereinafter, for convenience of explanation, an embodiment in which the protrusion is provided on one surface of the mask frame 451 will be described in detail.

The mask sheet 453 may be disposed to cover the opening area 451-1. An end of the mask sheet 453 may be seated on the protrusion of the mask frame 451. One mask sheet 453 may be provided. The mask sheet 453 may shield (or may cover) the entire opening area 451-1. In another embodiment, a plurality of mask sheets 453 may be provided, and the mask sheets 453 may be arranged adjacent to each other in one direction. For example, a longitudinal direction of each of the mask sheets 453 may be a direction tilted at an angle with respect to a straight line perpendicular to the lower surface of the chamber 410 (e.g., an oblique direction from the z-axis of FIG. 2). Also, a direction in which the mask sheets 453 are arranged (e.g., may be arranged adjacent to each other) may be a y-axis direction in FIG. 2. In such an embodiment, the mask sheets 453 may be arranged adjacent to each other to shield the opening area 451-1. Hereinafter, for convenience of explanation, an embodiment in which the mask sheets 453 are provided will be described in detail.

The mask sheets 453 may each include a plurality of pattern openings 453-1. In each of the mask sheets 453, the pattern openings 453-1 may be spaced apart from each other. The pattern openings 453-1 may be arranged in (or overlapping) the opening area 451-1.

The support member 452 may be between the mask sheet 453 and the mask frame 451 and may be configured to support the mask sheet 453 and partition the opening area 451-1 into a plurality of areas (e.g., a plurality of opening areas). The support member 452 may include a first support member 452-1 and a second support member 452-2, which are arranged in different directions from each other. The first support member 452-1 and the second support member 452-2 may be integrally formed as a single body or may be separately formed and bonded (or connected) to each other. Hereinafter, for convenience of explanation, an embodiment in which the first support member 452-1 and the second support member 452-2 are separately formed and connected to each other by welding or the like will be described in detail.

The support member 452 may be configured to support the mask sheet 453. An end of the support member 452 may be inserted into the mask frame 451 or may be on one surface of the mask frame 451.

The deposition source 420 may be configured to supply a deposition material to the mask assembly 450. The deposition source 420 may include a deposition material supply portion 421, a source portion 422, and a nozzle portion 423. The deposition source 420 may be arranged to face the mask assembly 450.

The deposition material supply portion 421 may be configured to receive a deposition material and supply the deposition material to the source portion 422. The deposition material supply portion 421 may be arranged outside or inside the chamber 410. The deposition material supply portion 421 may include a pump or the like so as to supply the deposition material to the source portion 422. Hereinafter, for convenience of explanation, an embodiment in which the deposition material supply portion 421 is arranged outside the chamber 410 will be described in detail.

The source portion 422 may be arranged inside the chamber 410 and may be connected to the deposition material supply portion 421 to vaporize or sublimate the deposition material. In such an embodiment, the source portion 422 may include a crucible in which the deposition material is accommodated and a heater configured to heat the crucible. In other words, the source portion 422 may be configured to accommodate and heat a deposition material.

The nozzle portion 423 may be connected to the source portion 422. The nozzle portion 423 may be connected to the source portion 422 via a pipe or the like. At least one nozzle portion 423 may be provided. The nozzle portion 423 may have a rectangular prism shape, and a long side of the nozzle portion 423 may be arranged obliquely with respect to a third direction (e.g., the z-axis direction of FIG. 3). In such an embodiment, the tilting angle θ4 of the nozzle portion 423 may be equal to or similar to the tilting angle θ2 of the mask assembly 450. The nozzle portion 423 may include a spray portion 423-1 through which the deposition material is sprayed. The spray portion 423-1 may have a circular hole (or opening) shape. In another embodiment, the spray portion 423-1 may be a hole (or opening) having a long slot shape. In another embodiment, the spray portion 423-1 may protrude from the outer surface of the nozzle portion 423. In another embodiment, the nozzle portion 423 may be elongated and be tilted with respect to the one plane parallel to the ground.

The pressure controller 460 may be connected to the chamber 410 and configured to control the internal pressure of the chamber 410. The pressure controller 460 may include a pipe 461 connected to the chamber 410 and a pump 462 arranged in (or along) the pipe 461.

The second inverting unit 5 may be configured to invert the carrier 700 drawn out from (e.g., after it passes through) the depositing unit 4. The second inverting unit 5 may be the same as or similar to the first inverting unit 2.

The unloading unit 6 may be configured to separate the display substrate DS from the carrier 700 after it is inverted by the second inverting unit 5 and unload the display substrate DS to the outside. For example, a separate robot arm or the like may be arranged inside or outside the unloading unit 6 to move the display substrate DS.

The mask assembly loading unit 3 may be configured to temporarily store the mask assembly 450 and then move the mask assembly 450 from the mask assembly loading unit 3 to the depositing unit 4. The mask assembly loading unit 3 may include a transfer portion 3-1, and the transfer portion 3-1 may be a robot arm, a shuttle, or the like. Hereinafter, for convenience of explanation, an embodiment in which the transfer portion 3-1 is a robot arm will be described in detail.

Linear drivers 7 may be individually arranged in the loading unit 1, the first inverting unit 2, the depositing unit 4, the second inverting unit 5, and the unloading unit 6. Ends of the linear drivers 7 individually arranged in the loading unit 1, the first inverting unit 2, the depositing unit 4, the second inverting unit 5, and the unloading unit 6 may be spaced apart from each other. In such an embodiment, a distance between the respective linear drivers 7 may be a distance within which the carrier 700 is movable (e.g., a distance smaller than a length of the carrier 700).

The linear driver 7 may use magnetic levitation. For example, the linear driver 7 may include a rail in the form of an electromagnet or a magnet. The linear driver 7 may also include a motion block 8 that moves along the rail. This motion block 8 may be connected to the carrier 700. A driver configured to rotate or tilt the carrier 700 may be arranged between the motion block 8 and the carrier 700.

The carrier 700 may include a carrier body 710 and a magnetic force generator 720. The carrier body 710 may include an electrostatic chuck (ESC). In some embodiments, the carrier body 710 may include a wireless charging module and a secondary battery. In some embodiments, the magnetic force generator 720 may be on a rear surface of the carrier body 710. In some embodiments, the magnetic force generator 720 may be on a side edge of the carrier body 710.

The magnetic force generator 720 may be in the form of an electromagnet. At least one magnetic force generator 720 may be provided. In an embodiment including a plurality of magnetic force generators 720, the magnetic force generators 720 may be arranged in a line. Also, the magnetic force generators 720 may be arranged in the height direction of the carrier body 710. Accordingly, the magnetic force generator 720 may be configured to provide a magnetic force so that the side portion of the mask assembly 450 is brought into close contact with the display substrate DS. Also, the magnetic force generators 720 are not arranged in a line above and below the mask assembly 450, thereby preventing the tilting angle θ2 of the tilted mask assembly 450 from changing.

The magnetic force generator 720 may include a first magnetic force generator 721 and a second magnetic force generator 722, which are spaced apart from each other. The first magnetic force generator 721 and the second magnetic force generator 722 may be arranged parallel to each other.

The apparatus 10 for manufacturing a display device of embodiments is not limited to the above. The first inverting unit 2 and the second inverting unit 5 may be omitted or only the mask assembly loading unit 3 may be provided. For example, in an embodiment in which the first inverting unit 2 and the second inverting unit 5 are omitted, the loading unit 1, the depositing unit 4, and the unloading unit 6 may be sequentially connected to each other in this order. In another embodiment, the apparatus 10 for manufacturing a display device may include only the depositing unit 4 or may include only the depositing unit 4 and the mask assembly loading unit 3. In another embodiment, the depositing unit 4 may be connected to other equipment. In another embodiment, the loading unit 1, the depositing unit 4, and the unloading unit 6 are sequentially connected to each other in this order. In such an embodiment, the mask assembly 450 may be transferred to the loading unit 1 together with the display substrate DS when the display substrate DS is disposed on the loading unit 1. In such an embodiment, the carrier 700 may be transported in a state in which both the display substrate DS and the mask assembly 450 are fixed. Hereinafter, for convenience of explanation, the apparatus 10 for manufacturing a display device as illustrated in FIG. 1 will be described in detail.

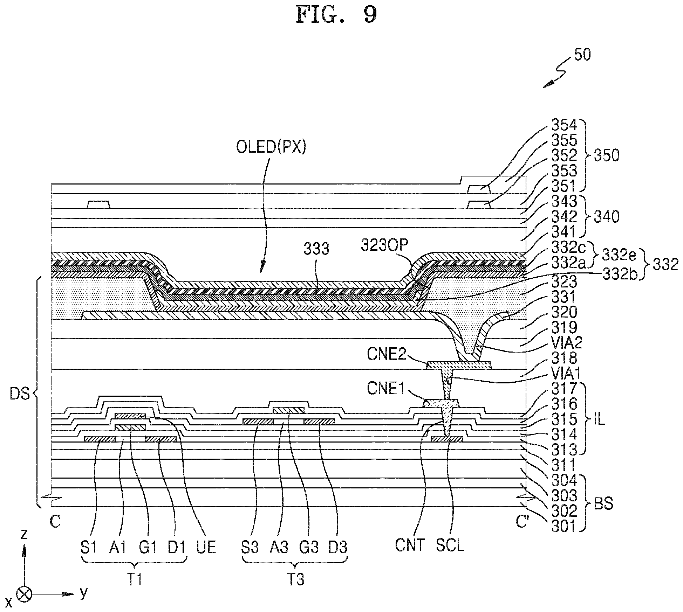

When the display device is manufactured by using the apparatus 10 for manufacturing a display device, the display substrate DS may be manufactured and fixed to the carrier 700(e.g. the carrier body 710) through the loading unit 1. As described below with reference to FIG. 9, the display substrate DS may include layers stacked thereon from a substrate BS to a pixel defining layer 323, may be stacked from the substrate BS to a first functional layer 332a, or may be stacked from the substrate BS to an emission layer 332b. Hereinafter, for convenience of explanation, an embodiment in which the display substrate DS is stacked from the substrate BS to the first functional layer 332a will be described in detail.

The carrier 700, to which the display substrate DS is attached, may move from the loading unit 1 to the first inverting unit 2. The carrier 700 may be inverted by the first inverting unit 2. The carrier 700 may move from the first inverting unit 2 to the depositing unit 4.

Before or after the carrier 700 is transferred to the depositing unit 4, the mask assembly loading unit 3 may transfer the mask assembly 450 to the depositing unit 4. The mask assembly loading unit 3 may place the mask assembly 450 on a support unit SU in a state of being tilted with respect to a straight line perpendicular to (or normal to) the lower surface of the chamber 410. The mask assembly 450 may be arranged on the support unit SU in a tilted state.

Deformation, which is caused by the load of the mask assembly 450, may be reduced when the mask assembly 450 is arranged as described above as compared to when the mask assembly 450 is arranged completely parallel to the lower surface of the chamber 410. In addition, deposition quality may be improved because deformation of the mask assembly 450 is reduced when compared to a case where the mask assembly 450 is arranged perpendicular to the lower surface of the chamber 410. That is, when the mask assembly 450 is arranged parallel to the lower surface of the chamber 410, the central portion of the mask sheet 453 may sag due to the load of each component of the mask assembly 450. Due to this sagging, the deposition material passing through the mask sheet 453 may not be deposited on the display substrate DS in a precise pattern. Also, when the mask assembly 450 is arranged perpendicular to the lower surface of the chamber 410, the upper portion of the mask frame 451 is bent, and thus, the mask sheet 453 is not supported. Accordingly, the deposition material may not be deposited on the display substrate DS in a precise pattern. However, when the deposition is performed in a state in which the mask assembly 450 is tilted with respect to the lower surface of the chamber 410, the above problem is mitigated, and thus, the deposition material may be deposited on the display substrate DS in a precise pattern.

After the carrier 700 is loaded into the chamber 410, the carrier 700 may arrange the display substrate DS in a tilted state similar to the mask assembly 450. For example, the carrier body 710 may be rotated by the driver 9 disposed on the motion block 8. The tilt angle θ1 of the carrier 700 may refer to an angle at which the carrier 700 is tilted with respect to the gravitational direction. The carrier 700 may be tilted to correspond to a tilting angle θ2 of the mask assembly 450.

The carrier 700, the display substrate DS, and the mask assembly 450 may maintain the state of being tilted with respect to a direction perpendicular to the lower surface of the chamber 410. The angles at which the carrier 700, the display substrate DS, and the mask assembly 450 are tilted with respect to a direction perpendicular to the lower surface of the chamber 410 may be equal to or substantially equal to each other.

When the above process is completed, the deposition source 420 may be operated to supply the deposition material to the display substrate DS. The magnetic force generator 720 may be configured to generate a magnetic force to bring the mask assembly 450 into close contact with the display substrate DS. In this case, the mask assembly 450, the carrier 700, the display substrate DS, and the support unit SU are not spaced apart from each other but may be arranged so that the mask assembly 450 and the display substrate DS are in close contact with each other.

The deposition material may be deposited on the display substrate DS through the pattern openings 453-1 in the mask sheet 453. For example, the deposition material passing through each of the pattern openings 453-1 in the mask sheet 453 may be arranged in an open area of a pixel defining layer 323 illustrated in, for example, FIG. 9. Accordingly, the deposition materials passing through the pattern openings 453-1 may be spaced apart from each other.

When the above process is completed, the carrier 700 may rotate again and then move from the depositing unit 4 to the second inverting unit 5 according to the operation of the linear driver 7. After the carrier 700 is inverted by the second inverting unit 5, the carrier 700 may move to the unloading unit 6. The unloading unit 6 may be configured to unload the display substrate DS, on which the deposition is completed, to the outside. Thereafter, the display device may be manufactured by arranging other layers on the display substrate DS.

In the apparatus 10 for manufacturing a display device and the method of manufacturing a display device, the deposition material may be deposited on the display substrate DS in a precise pattern by using the mask assembly 450 with minimal deformation.

The apparatus 10 for manufacturing a display device and the method of manufacturing a display device may be used to manufacture a display device that displays a clear image.

Referring to FIG. 4, pixel position accuracy (PPA) may change according to the tilting angle θ2 of the mask assembly 450. When the PPA changes rapidly according to the tilting angle θ2, the deposition material is not deposited at an accurate position. In that case, a pixel of the manufactured display device may not emit light or the planar areas of pixels emitting light of the same color may be different from each other, causing a problem in that picture quality of the display device is not clear. Also, when the PPA changes rapidly, deposition quality is not uniform. Accordingly, when deposition is repeated, display devices having different qualities from each other may be manufactured. In other words, a lower PPA is better, but it also important that the PPA does not change rapidly. However, when the tilting angle θ2 of the mask assembly 450 is less than about 3°, a section in which the PPA changes rapidly according to the tilting angle θ2 of the mask assembly 450 may occur. That is, when the tilting angle θ2 of the mask assembly 450 is less than about 3°, the entire mask assembly 450 is moved toward the carrier 700 due to the magnetic force generated by the magnetic force generator 720, causing a problem in that the tilting angle θ2 of the mask assembly 450 changes (e.g., locally changes) or the upper end of the mask frame 451 is bent toward the carrier 700. In this case, one surface of the display substrate DS and one surface of the mask assembly 450 are not parallel to each other, causing a problem in that the pattern of the deposition material deposited on the display substrate DS is different from the pattern of the pattern opening 453-1. Therefore, the tilting angle θ2 of the mask assembly 450 needs to be about 3° or more.

Also, when the tilting angle θ2 of the mask assembly 450 is less than about 3°, the deformation of the mask frame 451 may exceed about 50 µm. In this case, the mask sheet 453 may be different from the initial mask sheet due to the deformation of the mask frame 451. That is, because the mask sheet 453 is fixed to the mask frame 451 in a tensioned state, the mask sheet 453 may also be deformed when the mask frame 451 is deformed. In this case, the degree of deformation of the mask sheet 453 may also change according to the degree of deformation of the mask frame 451. In this case, the degree of deformation of the mask frame 451 may refer to a distance between the initial position of the outer surface of the mask frame 451 and the position of the outer surface of the mask frame 451, the position of which is changed from the initial position of the outer surface of the mask frame 451.

The deformation described above may occur in the support member 452. In this case, the mask frame 451 may be deformed according to the degree of change of the support member 452. For example, the degree of change of the support member 452 should not exceed about 250 µm. In this case, when the degree of change of the support member 452 exceeds about 250 µm, the support member 452 may not support (e.g., may not resist) the deformation of the mask frame 451, which is caused by the load of the mask frame 451. In this case, because the mask frame 451 is excessively deformed, the mask sheet 453 may also be deformed. In such a case, the degree of change of the support member 452 may refer to a distance at which a portion of the support member 452 is deformed when the support member 452 is maintained in a flat state and when the mask assembly 450 is maintained at a tilting angle θ2. For example, the degree of change of the support member 452 may refer to a maximum value from among points of the support member 452 at which the support member 452 is disposed at a position different from the initial position due to the load or the like. The change of the support member 452 may exceed about 250 µm when the tilting angle θ2 of the mask assembly 450 exceeds about 14°. Accordingly, when the mask assembly 450 is arranged at a tilting angle θ2 within a range of about 3° or more and about 14° or less, a display device including pixels having a precise pattern may be manufactured.

Referring to FIG. 5, when the tilting angle θ2 of the mask assembly 450 is less than about 3°, the extent to which the mask assembly 450 moves from the support unit SU toward the carrier 700 may be confirmed. That is, when the magnetic force generator 720 is operated at the initial position where the mask assembly 450 is disposed on the support unit SU, the upper end of the mask assembly 450 may move toward the carrier 700. At this time, when the tilting angle θ2 of the mask assembly 450 is less than about 3°, the upper end of the mask assembly 450 moves toward the carrier 700, and thus, the initial position of the mask assembly 450 may not be the same as the position of the mask assembly 450 when the magnetic force generator 720 is operated. In this case, the deposition material passing through the pattern opening 453-1 does not pass through the pattern opening 453-1 accurately or is deposited in a portion other than the position corresponding to the pattern opening 453-1. Accordingly, image quality of the manufactured display device may be unclear.

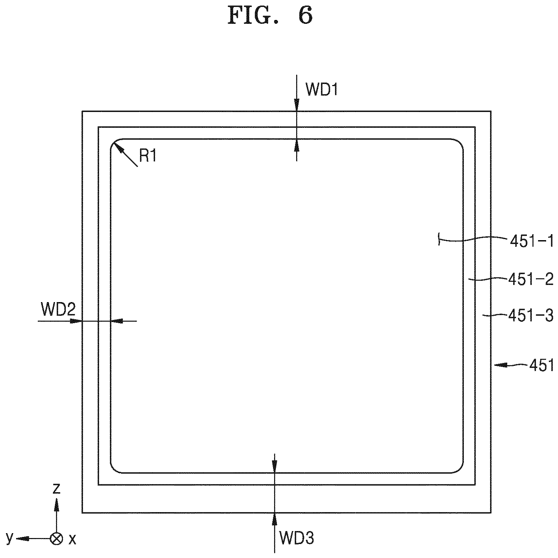

FIG. 6 is a front view of a mask frame 451 of a mask assembly in an apparatus for manufacturing a display device according to another embodiment.

Referring to FIG. 6, the mask frame 451 may have a flat surface with which a mask sheet is in contact. The mask frame 451 may include a protrusion 451-2 on which the mask sheet is seated and a stepped portion 451-3 that is formed to be stepped from the protrusion 451-2 and is not in contact with the mask sheet. A thickness of the protrusion 451-2 may be greater than a thickness of the stepped portion 451-3.

The mask frame 451 may have an opening area 451-1 having a rectangular shape. A corner portion of the opening area 451-1 may be rounded. For example, the corner portion of the opening area 451-1 may be a portion of a circle having a first radius R1. When the corner portion of the opening area 451-1 is rounded, stress may not be concentrated in the corner portion of the opening area 451-1.

The mask frame 451 may have a rectangular or square shape. In this case, widths of sides of the mask frame 451 may be different from each other. For example, a first mask frame width WD1 of a portion on the upper side of the mask frame 451 may be equal to a second mask frame width WD2 of another portion on the side of the mask frame 451. Also, a third mask frame width WD3 of another portion on the lower side of the mask frame 451 may be greater than the first mask frame width WD1 and the second mask frame width WD2. When the mask frame 451 is arranged vertically, a portion of the mask frame 451 having the third mask frame width WD3 may be disposed on the support block 440.

When the mask frame 451 is arranged vertically, the lower portion of the mask frame 451 is wider than the other portions thereof. Accordingly, deformation of the mask frame 451 due to the load thereof may be reduced.

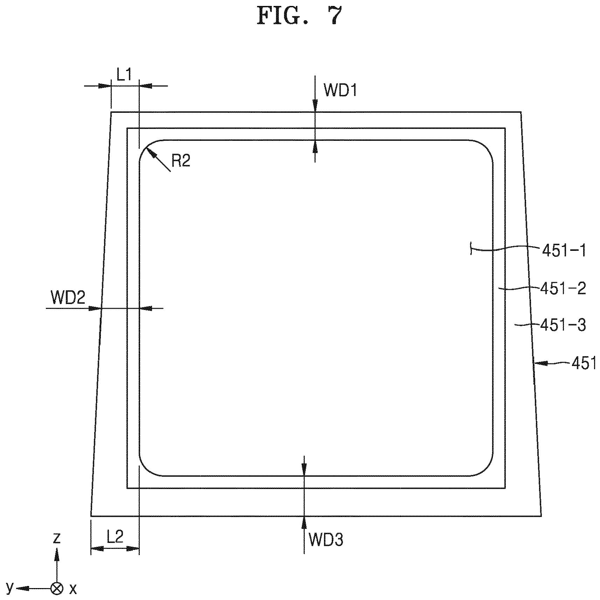

FIG. 7 is a front view of a mask frame 451 of a mask assembly in an apparatus for manufacturing a display device, according to another embodiment.

Referring to FIG. 7, the mask frame 451 of the mask assembly may have a trapezoidal planar shape. The mask frame 451 may include a protrusion 451-2 and a stepped portion 451-3 as described above.

In the mask frame 451, the third mask frame width WD3 of a lower side of the mask frame 451, which is a portion supported by a support block 440, may be greater than the first mask frame width WD1 of an upper side of the mask frame 451. In this case, the second mask frame width WD2 of a side surface of the mask frame 451 may increase from the upper side to the lower side. For example, an upper width L1 measured from an inner surface of an opening area 451-1 to an upper edge of the side surface of the mask frame 451 may be less than a lower width L2 measured from the inner surface of the opening area 451-1 to a lower edge of the side surface of the mask frame 451. In this case, the side surface of the mask frame 451 may be inclined.

Similar to the embodiment illustrated in FIG. 6, the corner portions of the opening area 451-1 may be rounded to have a second radius R2. At this time, the opening area 451-1 may have a rectangular or square shape and may have rounded corners.

The first mask frame width WD1, which is the width of the upper side of the mask frame 451, may be different from the third mask frame width WD3, which is the width of the lower side of the mask frame 451. For example, the first mask frame width WD1 may be less than the third mask frame width WD3.

In this case, the lower portion of the mask frame 451 may be stronger, and the load of the mask assembly 450 may be supported even when the mask frame 451 is tilted with respect to the ground or a plane parallel to the ground. Accordingly, the degree of deformation of the mask frame 451 may be reduced.

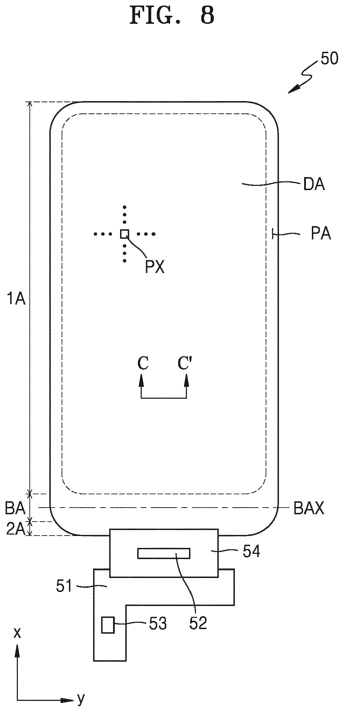

FIG. 8 is a plan view schematically illustrating a display device 50 according to an embodiment.

Referring to FIG. 8, in an embodiment, the display device 50 may have a display area DA and a peripheral area PA. Display elements (e.g., a plurality of pixels) are arranged in the display area DA of the display device 50 so that an image is displayed on the display area DA, and display elements are not arranged in the peripheral area PA of the display device 50 so that an image is not displayed on the peripheral area PA. The display elements may be a plurality of pixels PX. The pixels PX may be disposed in the display area DA to be spaced apart from each other. In an embodiment, some of the pixels PX and others of the pixels PX may emit light of different colors from each other. In another embodiment, all the pixels PX may emit light of the same color as each other.

The display device 50 may have a first area 1A including the display area DA, a portion of the peripheral area PA arranged adjacent to the display area DA, and a bending area BA including a bending axis BAX that is bent while being arranged in the peripheral area PA and a second area 2A connected to (or extending from) the bending area BA and arranged in the peripheral area PA. Terminals may be arranged in the second area 2A. The first area 1A may be an area that maintains a flat state or is folded.

In an embodiment, the display device 50 may include display elements. The display elements may be a light-emitting display device including a light-emitting diode (LED). In an embodiment, the display device 50 may be an organic light-emitting display device using an organic LED including an organic emission layer, a micro light-emitting display device using a micro LED, a quantum dot light-emitting display device using a quantum dot LED including a quantum dot emission layer, or an inorganic light-emitting display device using an inorganic light-emitting element including an inorganic semiconductor.

In an embodiment, the display device 50 may be a rigid display device that is difficult to bend due to its rigidity or may be a flexible display device that is bendable, foldable, or rollable due to its flexibility. For example, the display device 50 may be a foldable display device, a curved display device with a curved display surface, a bendable display device in which areas other than a display surface are bent, a rollable display device, or a stretchable display device.

The display device 50 may be a transparent display device that is implemented to be transparent so that an object or a background on (or behind) the lower surface of the display device 50 is visible from the upper surface of the display device 50. In other embodiments, the display device 50 may be a reflective display device configured to reflect an object or a background on the upper surface of the display device 50.

In an embodiment, a first flexible film 54 may be bonded to one edge of the display device 50. One side of the first flexible film 54 may be bonded to one edge of the display device 50 via an anisotropic conductive film. The first flexible film 54 may be a bendable flexible film.

In an embodiment, a display driver 52 may be disposed on the first flexible film 54. The display driver 52 may be configured to receive control signals and power supply voltages and to generate and output signals and voltages for driving the display device 50. The display driver 52 may be implemented as an integrated circuit (IC).

In an embodiment, a display circuit board 51 may be bonded to the other side of the first flexible film 54. The other side of the first flexible film 54 may be bonded to the upper surface of the display circuit board 51 via an anisotropic conductive film. The display circuit board 51 may be a flexible printed circuit board (FPCB) that is easily bendable, a rigid printed circuit board (PCB) that is rigid and thus hardly bendable, or a composite printed circuit board that includes both the rigid PCB and the FPCB.

In an embodiment, a touch sensor driver 53 may be disposed on the display circuit board 51. The touch sensor driver 53 may be implemented as an IC. The touch sensor driver 53 may be bonded on the display circuit board 51. The touch sensor driver 53 may be electrically connected through the display circuit board 51 to touch electrodes of a touch screen layer of the display device 50.

The touch screen layer of the display device 50 may be configured to sense a touch input of a user by using at least one of various touch methods, including a resistive method and a capacitive method. For example, when the touch screen layer of the display device 50 senses a touch input of a user by using a capacitive method, the touch sensor driver 53 may determine the touch or non-touch of the user by applying driving signals to driving electrodes from among the touch electrodes and sensing voltages charged in mutual capacitances between the driving electrodes and sensing electrodes through the sensing electrodes from among the touch electrodes. The touch of the user may include a contact touch and a proximity touch (or proximity event). The contact touch refers to direct contact of a user's finger or an object, such as a pen, with a cover member disposed on the touch screen layer. The proximity touch indicates that a user's finger or an object, such as a pen, is located near to but apart from the cover member, such as hovering. The touch sensor driver 53 may be configured to transmit sensor data to a main processor according to the sensed voltages, and the main processor may be configured to analyze the sensor data and to calculate touch coordinates at where the touch input has occurred.

A power supply configured to supply driving voltages for driving the pixels PX, the scan driver, and the display driver 52 of the display device 50 may be additionally disposed on the display circuit board 51. In some embodiments, the power supply may be integrated with the display driver 52. In such an embodiment, the display driver 52 and the power supply may be formed as a single IC.

FIG. 9 is a cross-sectional view of the display device 50 shown in FIG. 8 taken along the line C-C' in FIG. 8 according to an embodiment.

Referring to FIG. 9, the display device 50 may include a substrate BS, a buffer layer 311, insulating layers IL, a light-emitting element OLED, a thin-film encapsulation layer 340, and an input sensor 350.

The substrate BS may have a structure in which layers including organic materials and layers including inorganic materials are alternately stacked. For example, the substrate BS may include a first base layer 301, a first barrier layer 302, a second base layer 303, and a second barrier layer 304, which are sequentially stacked in this order.

The first base layer 301 may include an organic material. For example, the first base layer 301 may include one of polyimide, polyethylene naphthalate, polyethylene terephthalate, polyarylate, polycarbonate, polyetherimide, and polyethersulfone.

The first barrier layer 302 may be disposed on the first base layer 301. The first barrier layer 302 may include an inorganic material. For example, the first barrier layer 302 may include silicon oxide, silicon oxynitride, silicon nitride, amorphous silicon, or the like. In an embodiment, the first barrier layer 302 may include a first layer and a second layer, and the second layer may have a refractive index lower than a refractive index of the first layer. For example, the first layer may include silicon oxynitride, and the second layer may include silicon oxide having a refractive index lower than a refractive index of silicon oxynitride.

The second base layer 303 may be disposed on the first barrier layer 302. The second base layer 303 may include the same material as that of the first base layer 301. However, embodiments of the disclosure are not limited thereto, and in some embodiments, the second base layer 303 may include a material different from that of the first base layer 301. In an embodiment, a thickness of the second base layer 303 may be less than a thickness of the first base layer 301.

The second barrier layer 304 may be disposed on the second base layer 303. The second barrier layer 304 may include an inorganic material. For example, the second barrier layer 304 may include silicon oxide, silicon oxynitride, silicon nitride, or the like. In an embodiment, the second barrier layer 304 may include a first layer and a second layer, and the second layer may have a refractive index lower than a refractive index of the first layer. For example, the first layer may include silicon oxynitride, and the second layer may include silicon oxide having a refractive index lower than a refractive index of silicon oxynitride.

The buffer layer 311 may be disposed on the substrate BS. The buffer layer 311 may reduce or block infiltration of foreign material, moisture, or ambient air from below the substrate BS. The buffer layer 311 may include an inorganic material, such as silicon oxide, silicon oxynitride, or silicon nitride, and may include a single layer or layers including the material described above.

A semiconductor pattern may be disposed on the buffer layer 311. Hereinafter, a semiconductor pattern disposed directly on the buffer layer 311 is defined as a first semiconductor pattern. The first semiconductor pattern may include a silicon semiconductor. The first semiconductor pattern may include polysilicon. However, embodiments of the disclosure are not limited thereto, and in some embodiments, the first semiconductor pattern may include amorphous silicon.

FIG. 9 illustrates only a portion of the first semiconductor pattern, and the first semiconductor pattern may be further arranged in other areas of the pixel PX (see, e.g., FIG. 8). The first semiconductor pattern may include a doped region and an undoped region. The doped region may be doped with an N-type dopant or a P-type dopant. A P-type transistor may include a doped region doped with a P-type dopant.

A first transistor T1 may have a source area S1, an active area A1, and a drain area D1. The source area S1, the active area A1, and the drain area D1 of the first transistor T1 may be formed in pattern shape in a first semiconductor. The source area S1 and the drain area D1 of the first transistor T1 may be spaced apart from each other with the active area A1 of the first transistor T1 therebetween.

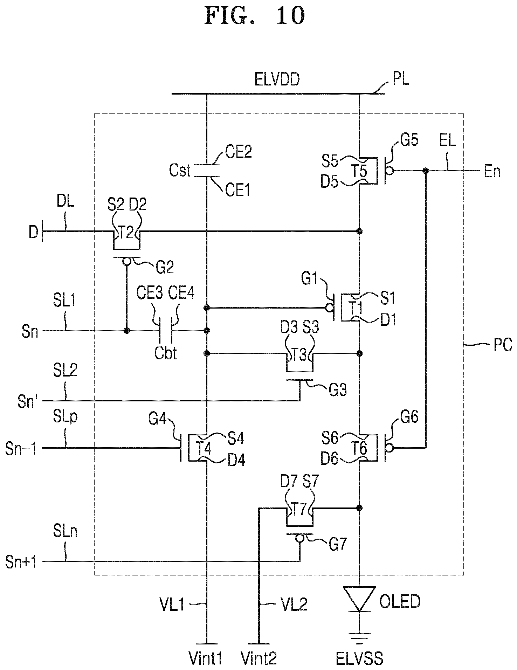

A connection signal line SCL may be disposed on the buffer layer 311. The connection signal line SCL may be connected to a drain area D6 (see, e.g., FIG. 10) of a sixth transistor T6 (see, e.g., FIG. 10) in a plan view. However, in some embodiments, the connection signal line SCL may be omitted.

A first insulating layer 313 may be disposed on the buffer layer 311. The first insulating layer 313 may cover the first semiconductor pattern. In an embodiment, the first insulating layer 313 may include an inorganic material, such as silicon oxide, silicon oxynitride, or silicon nitride, and may include a single layer or a plurality of layers including the material described above.

A gate G1 of the first transistor T1 may be disposed on the first insulating layer 313. The gate G1 of the first transistor T1 may be a portion of a metal pattern. The gate G1 of the first transistor T1 may at least partially overlap the first semiconductor pattern disposed therebelow. For example, the gate G1 of the first transistor T1 may overlap the active area A1 disposed therebelow. The gate G1 of the first transistor T1 may include a low-resistance conductive material, such as molybdenum (Mo), aluminum (Al), copper (Cu), and/or titanium (Ti), and may include a single layer or a plurality of layers including the material described above.

A second insulating layer 314 may be disposed on the first insulating layer 313. The second insulating layer 314 may cover the gate G1 of the first transistor T1 disposed on the first insulating layer 313. The second insulating layer 314 may include an inorganic material, such as silicon oxide, silicon oxynitride, or silicon nitride, and may include a single layer or a plurality of layers including the material described above.

An upper electrode UE may be disposed on the second insulating layer 314. The upper electrode UE may at least partially overlap the gate G1 of the first transistor T1 disposed therebelow. The upper electrode UE may be a portion of a metal pattern or a portion of a doped semiconductor pattern. A portion of the gate G1 and the upper electrode UE overlapping a portion of the gate G1 may constitute a first storage capacitor Cst (see, e.g., FIG. 10). However, in some embodiments, the upper electrode UE may be omitted.

A first electrode CE1 (see, e.g., FIG. 10) and a second electrode CE2 (see, e.g., FIG. 10) of the first storage capacitor Cst may be formed through the same process as the gate G1 and the upper electrode UE, respectively. The first electrode CE1 may be disposed on the first insulating layer 313, and the first electrode CE1 may be electrically connected to the gate G1. The first electrode CE1 may be integral with the gate G1.

A third insulating layer 315 may be disposed on the second insulating layer 314. The third insulating layer 315 may cover the upper electrode UE disposed on the second insulating layer 314. The third insulating layer 315 may include an inorganic material, such as silicon oxide, silicon oxynitride, or silicon nitride, and may include a single layer or a plurality of layers including the material described above. In an embodiment, the third insulating layer 315 may include a plurality of silicon oxide layers and a plurality of silicon nitride layers, which are alternately stacked.

Source areas S2, S5, S6, and S7 (see, e.g., FIG. 10), drain areas D2, D5, D6, and D7 (see, e.g., FIG. 10), and gates G2, G5, G6, and G7 (see, e.g., FIG. 10) of second, fifth, sixth, and seventh transistors T2, T5, T6, and T7 (see, e.g., FIG. 10) may be formed through the same process as the source area S1, the drain area D1, and the gate G1 of the first transistor T1.

A semiconductor pattern may be disposed on the third insulating layer 315. Hereinafter, the semiconductor pattern disposed directly on the third insulating layer 315 is defined as a second semiconductor pattern. The second semiconductor pattern may include an oxide semiconductor. The oxide semiconductor may include a crystalline or amorphous oxide semiconductor.

For example, the oxide semiconductor may include at least one selected from indium (In), gallium (Ga), tin (Sn), zirconium (Zr), vanadium (V), hafnium (Hf), cadmium (Cd), germanium (Ge), chromium (Cr), titanium (Ti), and zinc (Zn). In some embodiments, the oxide semiconductor may include indium tin oxide (ITO), indium gallium zinc oxide (IGZO), zinc oxide (ZnO), indium zinc oxide (IZO), zinc indium oxide (ZIO), indium oxide (InO), titanium oxide (TiO), indium zinc tin oxide (IZTO), zinc tin oxide (ZTO), and the like.

A third transistor T3 may have a source area S3, an active area A3, and a drain area D3. The source area S3, the active area A3, and the drain area D3 of the third transistor T3 may be formed in a pattern shape in a second semiconductor. The source area S3 and the drain area D3 of the third transistor T3 may include a metal reduced from a metal oxide semiconductor. The source area S3 and the drain area D3 of the third transistor T3 may include a metal layer that includes a reduced metal and has a thickness from the upper surface of the second semiconductor pattern.

A fourth insulating layer 316 may be disposed on the third insulating layer 315. The fourth insulating layer 316 may cover the second semiconductor pattern disposed on the third insulating layer 315. In an embodiment, the fourth insulating layer 316 may include an inorganic material, such as silicon oxide, silicon oxynitride, or silicon nitride, and may include a single layer or a plurality of layers including the material described above.

In an embodiment, the fourth insulating layer 316 may be patterned to correspond to a gate G3 of the third transistor T3 disposed thereon. For example, the gate G3 of the third transistor T3 and the fourth insulating layer 316 may have the same shape in a plan view.

The gate G3 of the third transistor T3 may be disposed on the fourth insulating layer 316. The gate G3 of the third transistor T3 may be a portion of a metal pattern. The gate G3 of the third transistor T3 may at least partially overlap the second semiconductor pattern disposed therebelow. For example, the gate G3 of the third transistor T3 may overlap the active area A3 disposed therebelow. The gate G3 of the third transistor T3 may include a low-resistance conductive material, such as molybdenum (Mo), aluminum (Al), copper (Cu), and/or titanium (Ti), and may include a single layer or a plurality of layers including the material described above.

A fifth insulating layer 317 may be disposed on the fourth insulating layer 316. The fifth insulating layer 317 may cover the gate G3 disposed on the fourth insulating layer 316. In an embodiment, the fifth insulating layer 317 may include an inorganic material, such as silicon oxide, silicon oxynitride, or silicon nitride, and may include a single layer or a plurality of layers including the material described above. In an embodiment, the fifth insulating layer 317 may include a plurality of silicon oxide layers and a plurality of silicon nitride layers, which are alternately stacked.

A source area S4 (see, e.g., FIG. 10), a drain area D4 (see, e.g., FIG. 10), and a gate G4 (see, e.g., FIG. 10) of a fourth transistor T4 (see, e.g., FIG. 10) may be formed through the same process as the source area S3, the drain area D3, and the gate G3 of the third transistor T3.

The first to fifth insulating layers 313 to 317 may be collectively referred to as the insulating layers IL. However, at least one of the first to fifth insulating layers 313 to 317 may be omitted.

At least one organic insulating layer may be disposed on the fifth insulating layer 317. In an embodiment, a first organic insulating layer 318, a second organic insulating layer 319, and a third organic insulating layer 320 may be disposed on the fifth insulating layer 317. The first organic insulating layer 318, the second organic insulating layer 319, and the third organic insulating layer 320 may each be a single polyimide-based resin layer. However, embodiments of the disclosure are not limited thereto. In some embodiments, the first organic insulating layer 318, the second organic insulating layer 319, and the third organic insulating layer 320 may each include at least one selected from acrylic resin, methacrylic resin, polyisoprene-based resin, vinyl-based resin, epoxy-based resin, urethane-based resin, cellulose-based resin, siloxane-based resin, polyamide-based resin, and perylene-based resin.

A first connection electrode CNE1 may be disposed on the fifth insulating layer 317. The first connection electrode CNE1 may be connected to the connection signal line SCL through contact holes (e.g., contact openings) CNT defined in the first to fifth insulating layers 313 to 317.

A second connection electrode CNE2 may be disposed on the first organic insulating layer 318. The second connection electrode CNE2 may be connected to the first connection electrode CNE1 through a first via hole (e.g., a first via opening) VIA1 defined in the first organic insulating layer 318.

A light-emitting element OLED, which is a display element, may be disposed on the third organic insulating layer 320. In such an embodiment, a plurality of light-emitting elements OLED may be provided to be spaced apart from each other. The light-emitting element OLED may include a pixel electrode 331, an intermediate layer 332, and an opposite electrode 333. The pixel electrode 331 may be disposed on the third organic insulating layer 320. Also, a pixel defining layer 323 may be disposed on the third organic insulating layer 320.

The pixel electrode 331 may be disposed on the third organic insulating layer 320. The pixel electrode 331 may be electrically connected to the second connection electrode CNE2 through a second via hole (e.g., a second via opening) VIA2 defined in the second organic insulating layer 319 and the third organic insulating layer 320. The pixel electrode 331 may include a conductive oxide, such as indium tin oxide (ITO), indium zinc oxide (IZO), zinc oxide (ZnO), indium oxide (In₂O₃), indium gallium oxide (IGO), or aluminum zinc oxide (AZO). In an embodiment, the pixel electrode 331 may include a reflective layer including silver (Ag), magnesium (Mg), aluminum (Al), platinum (Pt), palladium (Pd), gold (Au), nickel (Ni), neodymium (Nd), iridium (Ir), chromium (Cr), or any compound thereof. In an embodiment, the pixel electrode 331 may further include a layer including ITO, IZO, ZnO, or In₂O₃ above and/or below the reflective layer. For example, the pixel electrode 331 may have a multilayer structure of ITO/Ag/ITO.

The pixel defining layer 323 having an opening 323OP exposing at least a portion of the pixel electrode 331 may be disposed on the pixel electrode 331. The opening 323OP in the pixel defining layer 323 may define an emission area of light emitted from the light-emitting element OLED. For example, the width of the opening 323OP may correspond to the width of the emission area. A non-emission area may be at a periphery of the emission area, and the non-emission area may surround (e.g., may surround in a plan view or extend around a periphery of) the emission area.

The pixel defining layer 323 may include an organic insulating material. In some embodiments, the pixel defining layer 323 may include an inorganic insulating material, such as silicon nitride, silicon oxynitride, or silicon oxide. In some embodiments, the pixel defining layer 323 may include an organic insulating material and an inorganic insulating material. In some embodiments, the pixel defining layer 323 may include a light blocking material and may be provided in black. The light blocking material may include a resin or paste including carbon black, carbon nanotubes or black dye, metal particles (e.g., nickel, aluminum, molybdenum, and any alloy thereof), metal oxide particles (e.g., chromium oxide), or metal nitride particles (e.g., chromium nitride). When the pixel defining layer 323 includes a light blocking material, the reflection of external light due to the metal structures below the pixel defining layer 323 may be reduced.

A spacer may be disposed on the pixel defining layer 323. The spacer may include an organic insulating material, such as polyimide. In some embodiments, the spacer may include an inorganic insulating material, such as silicon nitride (SiNₓ) or silicon oxide (SiOₓ), or may include an organic insulating material and an inorganic insulating material.

In an embodiment, the spacer may include the same material as that of the pixel defining layer 323. In such an embodiment, the pixel defining layer 323 and the spacer may be formed together (e.g., may be formed concurrently) in a mask process by using a halftone mask or the like. In an embodiment, the spacer and the pixel defining layer 323 may include different materials from each other.

The intermediate layer 332 may be disposed on the pixel electrode 331. The intermediate layer 332 may include a first functional layer 332a, an emission layer 332b, and a second functional layer 332c, which are sequentially stacked in this stated order. The first functional layer 332a and the second functional layer 332c may be collectively referred to as an organic functional layer 332e.

The emission layer 332b may be disposed in the opening 323OP in the pixel defining layer 323. The emission layer 332b may include a high molecular weight organic material or a low molecular weight organic material that emits light of a certain color. In such an embodiment, the light-emitting elements OLED may emit light of different colors from each other according to the type of material of the emission layer 332b. The emission layers 332b may be spaced apart from each other and may have a certain pattern. Also, some of the emission layers 332b, others of the emission layers 332b, and others of the emission layers 332b may include different materials from each other.

The organic functional layer 332e may include a first functional layer 332a between the pixel electrode 331 and the emission layer 332b, and a second functional layer 332c between the emission layer 332b and the opposite electrode 333. For example, the first functional layer 332a may be between the pixel electrode 331 and the emission layer 332b, and the second functional layer 332c may be omitted between the emission layer 332b and the opposite electrode 333. In an embodiment, the first functional layer 332a may be omitted between the pixel electrode 331 and the emission layer 332b, and the second functional layer 332c may be between the emission layer 332b and the opposite electrode 333. In an embodiment, the first functional layer 332a may be between the pixel electrode 331 and the emission layer 332b, and the second functional layer 332c may be between the emission layer 332b and the opposite electrode 333. Hereinafter, an embodiment in which the first functional layer 332a and the second functional layer 332c are disposed will be described in detail.

The first functional layer 332a may include, for example, a hole transport layer (HTL), or may include an HTL and a hole injection layer (HIL). The second functional layer 332c may include an electron transport layer (ETL) and/or an electron injection layer (EIL). The first functional layer 332a and/or the second functional layer 332c may be a common layer completely covering the substrate BS.

At least one of the first functional layer 332a, the emission layer 332b, and the second functional layer 332c may be formed in the form of a pattern. For example, at least one of the first functional layer 332a, the emission layer 332b, and the second functional layer 332c is provided in plurality. At least one of the first functional layers 332a, the emission layers 332b, and the second functional layers 332c may be spaced apart from each other to correspond to each light-emitting element OLED. Hereinafter, for convenience of explanation, an embodiment in which the first functional layer 332a and the second functional layer 332c are on the front surface of the substrate BS and the emission layers 332b are spaced apart from each other will be described in detail.

The opposite electrode 333 may include a conductive material having a low work function. For example, the opposite electrode 333 may include a (semi)transparent layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), or any alloy thereof. In some embodiments, the opposite electrode 333 may further include a layer including ITO, IZO, ZnO, or In₂O₃ on the (semi)transparent layer including the material described above.

A capping layer may be further disposed on the opposite electrode 333. The capping layer may include an inorganic material such as lithium fluoride (LiF),, and/or an organic material.

An encapsulation member may be disposed on the light-emitting element OLED. The encapsulation member may include a thin-film encapsulation layer 340. An embodiment in which the thin-film encapsulation layer 340 is provided as the encapsulation member is illustrated, but embodiments of the disclosure are not limited thereto. For example, the encapsulation member may include an encapsulation substrate and a sealing portion connecting the encapsulation substrate to the substrate.

The thin-film encapsulation layer 340 may include at least one inorganic layer and at least one organic layer. For example, the thin-film encapsulation layer 340 may include a first inorganic layer 341, an organic layer 342, and a second inorganic layer 343, which are sequentially stacked in this order.

The first inorganic layer 341 may be disposed directly on the opposite electrode 333. The first inorganic layer 341 may prevent or minimize infiltration of external moisture or oxygen into the light-emitting element OLED.

The organic layer 342 may be disposed directly on the first inorganic layer 341. The organic layer 342 may provide a flat surface on the first inorganic layer 341. Because curves or particles formed on the upper surface of the first inorganic layer 341 are covered by the organic layer 342, the influence of the surface state of the upper surface of the first inorganic layer 341 on the components formed on the organic layer 342 may be reduced or blocked.

The second inorganic layer 343 may be disposed directly on organic layer 342. The second inorganic layer 343 may prevent or minimize release of moisture from the organic layer 342 to the outside.

The first inorganic layer 341 and the second inorganic layer 343 may include at least one inorganic material selected from aluminum oxide, titanium oxide, tantalum oxide, hafnium oxide, zinc oxide, silicon oxide, silicon nitride, and silicon oxynitride. The first inorganic layer 341 and the second inorganic layer 343 may be a single layer or a plurality of layers including the material described above. The organic layer 342 may include a polymer-based material. The polymer-based material may include acrylic resin, epoxy-based resin, polyimide, polyethylene, and the like. In an embodiment, the organic layer 342 may include acrylate.

The input sensor 350 may be disposed on the encapsulation member. The input sensor 350 may include a plurality of conductive patterns 352 and 354, a first sensing insulating layer 351, a second sensing insulating layer 353, and a third sensing insulating layer 355.

The first sensing insulating layer 351 may be disposed on the encapsulation member. The first conductive patterns 352 may be disposed on the first sensing insulating layer 351 and may be covered by the second sensing insulating layer 353. Also, the second conductive patterns 354 may be disposed on the second sensing insulating layer 353 and may be covered by the third sensing insulating layer 355. The first sensing insulating layer 351, the second sensing insulating layer 353, and the third sensing insulating layer 355 may each include an inorganic material and/or an organic material.

The conductive patterns 352 and 354 may each be conductive. The conductive patterns 352 and 354 may each be provided as a single layer or a plurality of layers. Also, at least one of the conductive patterns 352 and 354 may be provided as mesh lines in a plan view.

The mesh lines constituting the conductive patterns 352 and 354 may not overlap the emission layer 332b in a plan view. Accordingly, even when the input sensor 350 is formed directly on the display device 50, light emitted from pixels PX of a display panel may be provided to a user without interference from the input sensor 350.

FIG. 10 is an equivalent circuit diagram schematically illustrating the pixel of the display device illustrated in FIG. 8 according to an embodiment.

Referring to FIG. 10, in an embodiment, a pixel circuit PC may include a first transistor T1, a second transistor T2, a third transistor T3, a fourth transistor T4, a fifth transistor T5, a sixth transistor T6, a seventh transistor T7, a first storage capacitor Cst, and a second storage capacitor Cbt. In an embodiment, at least one of the first to seventh transistors T1 to T7 may be omitted.

The first to seventh transistors T1, T2, T3, T4, T5, T6, and T7 and the first and second storage capacitors Cst and Cbt may be connected to signal lines, a first initialization voltage line VL1, a second initialization voltage line VL2, and a driving voltage line PL. The signal lines may include a data line DL, a first scan line SL1, a second scan line SL2, a previous scan line SLp, a next scan line SLn, and an emission control line EL. In an embodiment, the signal lines, the first and second initialization voltage lines VL1 and VL2, and/or the driving voltage line PL may be shared by neighboring pixels.

The driving voltage line PL may be configured to transmit a first driving voltage ELVDD to the pixel circuit PC. The first initialization voltage line VL1 may be configured to transmit, to the pixel circuit PC, a first initialization voltage Vint1 for initializing the first transistor T1. The second initialization voltage line VL2 may be configured to transmit, to the pixel circuit PC, a second initialization voltage Vint2 for initializing the light-emitting element OLED.

From among the first to seventh transistors T1 to T7, the third and fourth transistors T3 and T4 may be implemented as n-channel metal-oxide semiconductor field effect transistor (MOSFET) (NMOS), and the others may be implemented as p-channel MOSFET (PMOS). However, embodiments of the disclosure are not limited thereto. In an embodiment, the third transistor T3, the fourth transistor T4, and the seventh transistor T7 may be implemented as NMOS, and the others may be implemented as PMOS.

As used herein, the expression "a transistor and a signal line, or a transistor and a transistor are electrically connected to each other" means "a source, a drain, and a gate of a transistor are integral with a signal line or are connected to each other through a connection electrode."

The first transistor T1 may be configured to control the magnitude of a driving current flowing from the driving voltage line PL to the light-emitting element OLED according to a gate voltage. The first transistor T1 may include a gate G1 connected to a first electrode CE1 of the first storage capacitor Cst, and a source area S1 connected to the driving voltage line PL through the fifth transistor T5. Also, the first transistor T1 may include a drain area D1 connected to the light-emitting element OLED through the sixth transistor T6.

The second transistor T2 may be configured to receive a data voltage D in response to a first scan signal Sn. The second transistor T2 may be configured to transmit the data voltage D to the source area S1 of the first transistor T1 in response to the first scan signal Sn. The second transistor T2 may include a gate G2 connected to the first scan line SL1, a source area S2 connected to the data line DL, and a drain area D2 connected to the source area S1 of the first transistor T1.

The first storage capacitor Cst may be connected between the driving voltage line PL and the first transistor T1. The first storage capacitor Cst may include a second electrode CE2 connected to the driving voltage line PL, and the first electrode CE1 connected to the gate G1 of the first transistor T1. The first storage capacitor Cst may be configured to store the difference between the first driving voltage ELVDD applied to the driving voltage line PL and the gate voltage of the first transistor T1 and to maintain the gate voltage of the first transistor T1.

The third transistor T3 may be connected in series between the drain area D1 and the gate G1 of the first transistor T1 and may connect the drain area D1 and the gate G1 of the first transistor T1 to each other in response to a second scan signal Sn'. The third transistor T3 may include a gate G3 connected to the second scan line SL2, a source area S3 connected to the drain area D1 of the first transistor T1, and a drain area D3 connected to the gate G1 of the first transistor T1. The third transistor T3 may include a plurality of transistors that are connected in series to each other and are concurrently (or simultaneously) controlled by the second scan signal Sn'. However, the third transistor T3 may be omitted.

When the third transistor T3 is turned on in response to the second scan signal Sn', the drain area D1 and the gate G1 of the first transistor T1 are connected to each other. That is, the first transistor T1 is diode-connected.

The fourth transistor T4 may be configured to apply the first initialization voltage Vint1 to the gate G1 of the first transistor T1 in response to a previous scan signal Sn-1. The fourth transistor T4 may include a gate G4 connected to the previous scan line SLp, a source area S4 connected to the gate G1 of the first transistor T1, and a drain area D4 connected to the first initialization voltage line VL1. The fourth transistor T4 may include a plurality of transistors that are connected in series to each other and are concurrently (e.g., simultaneously) controlled by the previous scan signal Sn-1. However, in some embodiments, the fourth transistor T4 may be omitted.

The fifth transistor T5 may connect the driving voltage line PL to the source area S1 of the first transistor T1 in response to an emission control signal En. The fifth transistor T5 may include a gate G5 connected to the emission control line EL, a source area S5 connected to the driving voltage line PL, and a drain area D5 connected to the source area S1 of the first transistor T1. However, in some embodiments, the fifth transistor T5 may be omitted.

The sixth transistor T6 may connect the drain area D1 of the first transistor T1 to an anode of the light-emitting element OLED in response to the emission control signal En. The sixth transistor T6 may be configured to transmit the driving current output from the first transistor T1 to the anode of the light-emitting element OLED. The sixth transistor T6 may include a gate G6 connected to the emission control line EL, a source area S6 connected to the drain area D1 of the first transistor T1, and a drain area D6 connected to the anode of the light-emitting element OLED. However, in some embodiments, the sixth transistor T6 may be omitted.

The seventh transistor T7 may be configured to apply the second initialization voltage Vint2 to the anode of the light-emitting element OLED in response to a next scan signal Sn+1. The seventh transistor T7 may include a gate G7 connected to the next scan line SLn, a source area S7 connected to the anode of the light-emitting element OLED, and a drain area D7 connected to the second initialization voltage line VL2. However, in some embodiments, the seventh transistor T7 may be omitted. The cathode of the light emitting element OLED may receive a second driving voltage or common voltage ELVSS.

As illustrated in FIG. 10, the seventh transistor T7 may be connected to the next scan line SLn. In other embodiments, the seventh transistor T7 may be connected to the emission control line EL and driven in response to the emission control signal En. In other embodiments, the seventh transistor T7 may be connected to the previous scan line SLp and driven in response to the previous scan signal Sn-1.

The positions of the sources and the drains may be changed with each other according to the type of transistor (p-type or n-type).

The second storage capacitor Cbt may include a third electrode CE3 and a fourth electrode CE4. The fourth electrode CE4 of the second storage capacitor Cbt may be connected to the first electrode CE1 of the first storage capacitor Cst, and the third electrode CE3 of the second storage capacitor Cbt may be configured to receive the first scan signal Sn. The second storage capacitor Cbt may be configured to compensate for the voltage drop at the gate G1 of the first transistor T1 by increasing the voltage of the gate G1 of the first transistor T1 at the time when the supply of the first scan signal Sn is stopped. However, in some embodiments, the second storage capacitor Cbt may be omitted.

As discussed, embodiments may provide an apparatus for manufacturing a display device, the apparatus comprising: a mask assembly tilted with respect to one plane parallel to a ground; a support unit configured to support one surface of the mask assembly and to support a lower surface of the mask assembly; a deposition source arranged to face the mask assembly; and a carrier arranged to face the mask assembly and configured to support a display substrate.

The apparatus for manufacturing a display device may comprise a chamber.

The support unit may be configured to support the mask assembly such that it is tilted with respect to the lower surface of the chamber (or the ground). For example, the mask assembly may be arranged inside the chamber in an upright state, and the support unit may be configured to maintain the mask assembly in an upright state.

The support unit may include a support portion having an opening arranged at a central portion thereof and a plurality of support blocks arranged on the surface of the support portion.

The support portion may have a window frame shape with the opening arranged at a central portion thereof. The opening may be provided such that a deposition material supplied from the deposition source passes therethrough. In such an embodiment, one surface of the support portion may have a flat shape. The support portion may be connected to the chamber. For example, support portion 430 may be fixed to the lower surface of the chamber or may be connected to the inner surface of the chamber via a separate structure.

The support unit may be configured to support the mask assembly in a tilted state. For example, the upper portion of the mask assembly may be tilted more toward (e.g., may be closer to) the deposition source than the lower portion of the mask assembly. The tilting angle of the mask assembly may be in a range of about 3° or more and about 14° or less. The tilting angle of the mask assembly may refer to an angle of one flat surface of the mask assembly with respect to a line segment perpendicular to the lower surface of the chamber (or the ground). The tilting angle of the mask assembly may refer to an angle at which the mask assembly is tilted with respect to the gravitational direction.

The mask assembly may include a mask frame, a mask sheet, and a support member.

An opening area (e.g., an opening) may be at the center region of the mask frame.

The mask sheet may be disposed to shield (e.g., to cover) the opening area. In one embodiment, one mask sheet may be provided, and the one mask sheet may entirely cover the opening area. In another embodiment, a plurality of mask sheets may be provided, and the plurality of mask sheets may be arranged adjacent to each other and may be arranged in one direction.

Each mask sheet may include a plurality of pattern openings. The plurality of pattern openings may be arranged to be spaced apart from each other in each mask sheet. The plurality of pattern openings may be arranged in the opening area.

The support member may be arranged between the mask sheet and the mask frame to support the mask sheet and to partition the opening area into a plurality of opening areas. The support member may include a first support member and a second support member arranged in different directions.

The deposition source facing the mask assembly may be correspondingly tiled with respect to a plane parallel to the ground. The deposition source may comprise a nozzle portion, and an angle at which the nozzle portion is tilted may be the same as or similar to the angle at which the mask assembly is tilted.

The deposition source may include a deposition material supplier, a source portion, and the nozzle portion.

The deposition material supplier may receive a deposition material and may provide the deposition material to the source portion. The source portion may be arranged inside the chamber and may be connected to the deposition material supplier to vaporize or sublimate the deposition material. The source portion may include a crucible in which a deposition material is accommodated and a heater to heat the crucible.

The nozzle portion may be connected to the source portion. For example, the nozzle portion may be connected to the source portion via a pipe or the like. The nozzle portion may include at least one nozzle. The nozzle portion may be formed to have a rectangular column shape, and a long side portion of the nozzle portion may be disposed obliquely. The nozzle portion may include a spray portion through which the deposition material is sprayed.

As discussed, embodiments may provide a method of manufacturing a display device, the method comprising: fixing a display substrate to a carrier; arranging a mask assembly to be tilted with respect to one plane parallel to a ground; and arranging one surface of the display substrate to face one surface of the mask assembly, wherein the mask assembly is supported by a first support block on a rear surface of the mask assembly and a second support block configured to support a lower surface of the mask assembly.

Such a method may use any of the apparatuses for manufacturing a display device discussed in relation to embodiments of the invention.

The apparatus for manufacturing a display device and the method of manufacturing a display device according to embodiments of the present disclosure may manufacture a display device having a precise pattern. The apparatus for manufacturing a display device and the method of manufacturing a display device according to embodiments of the present disclosure may reduce or minimize deformation of the mask assembly during the manufacturing of the display device.

It should be understood that the embodiments described herein should be considered in a descriptive sense and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the spirit and scope as defined by the following claims and their equivalents.

## Claims

1. An apparatus for manufacturing a display device, the apparatus comprising:
a mask assembly tilted with respect to one plane parallel to a ground;
a support unit configured to support one surface of the mask assembly and to support a lower surface of the mask assembly;
a deposition source arranged to face the mask assembly; and
a carrier arranged to face the mask assembly and configured to support a display substrate.

2. The apparatus of claim 1, wherein the support unit comprises:
a support portion having an opening;
a first support block spaced apart from the support portion and configured to support a rear surface of the mask assembly; and
a second support block on a lower surface of the support portion and configured to support a side surface of the mask assembly.

3. The apparatus of claim 1 or 2, wherein a tilting angle of the mask assembly is in a range of 3° to 14°.

4. The apparatus of any one of claims 1 to 3, wherein the carrier is tilted to correspond to a tilting angle of the mask assembly.

5. The apparatus of any one of claims 1 to 4, wherein the mask assembly comprises:
a mask frame; and
a mask sheet on the mask frame.

6. The apparatus of claim 5, wherein the mask assembly further comprises a support member arranged over an opening in the mask frame to partition the opening in the mask frame.

7. The apparatus of any one of claims 1 to 6, wherein the deposition source comprises:
a source portion configured to accommodate and heat a deposition material; and
a nozzle portion connected to the source portion and configured to spray the heated deposition material in the source portion.

8. The apparatus of claim 7, wherein the nozzle portion is elongated and is tilted with respect to the one plane parallel to the ground.

9. The apparatus of any one of claims 1 to 8, wherein the carrier comprises:
a carrier body configured to fix the display substrate; and
a magnetic force generator on a rear surface of the carrier body.

10. The apparatus of claim 9, wherein the magnetic force generator is on a side surface of the carrier body.

11. A method of manufacturing a display device, the method comprising:
fixing a display substrate to a carrier;
arranging a mask assembly to be tilted with respect to one plane parallel to a ground; and
arranging one surface of the display substrate to face one surface of the mask assembly,
wherein the mask assembly is supported by a first support block on a rear surface of the mask assembly and a second support block configured to support a lower surface of the mask assembly.

12. The method of claim 11, wherein the mask assembly comprises:
a mask frame having an opening; and
a mask sheet on the mask frame;
optionally wherein the mask assembly further comprises a support member arranged over the opening in the mask frame to partition the opening in the mask frame.

13. The method of claim 11 or 12, further comprising arranging the mask assembly on a support portion on which the first support block and the second support block are arranged.

14. The method of any one of claim 11, wherein the carrier is tilted to correspond to an angle at which the mask assembly is tilted.

15. The method of any one of claims 11 to 14, further comprising depositing a deposition material on the display substrate by supplying the deposition material through a deposition source;
optionally wherein the deposition source comprises: a source portion configured to accommodate and heat a deposition material; and a nozzle portion connected to the source portion and configured to spray the deposition material heated in the source portion;
optionally wherein the nozzle portion is elongated and is tilted with respect to the one plane parallel to the ground.
